# EUROPEAN PATENT APPLICATION

(11) **EP 4 071 841 A1**
(43) Date of publication of application: **12.10.2022**
(21) Application number: 20940352.6
(22) Date of filing: 12.06.2020
(51) Int. Cl.: H01L 51/52, H01L 27/32

(54) **DISPLAY PANEL AND MANUFACTURING METHOD THEREFOR, AND DISPLAY DEVICE**

(71) Applicant: BOE Technology Group Co., Ltd., Beijing 100015 (CN); Hefei Xinsheng Optoelectronics Technology Co., Ltd., Xinzhan Industrial Park Hefei Anhui 230012 (CN)
(72) Inventor: GAO, Xinwei, Beijing 100176 (CN); ZHANG, Dacheng, Beijing 100176 (CN); LIU, Lang, Beijing 100176 (CN); XU, Chen, Beijing 100176 (CN)
(74) Representative: Maiwald Patent- und Rechtsanwaltsgesellschaft mbH
(86) International application number: PCT/CN2020/095761
(87) International publication number: WO 2021/248434

(57) **Abstract**

A display panel and a manufacturing method therefor, and a display device. The display panel comprises an array substrate, a packaging cover plate, and a sealant. The array substrate comprises a display region and a non-display region at least partially surrounding the display region. The display region comprises a plurality of pixels arranged in an array, each pixel comprises a plurality of sub-pixels, and each sub-pixel comprises a light emitting component. The packaging cover plate is disposed opposite to the array substrate, and comprises a first substrate and a plurality of organic layers. The plurality of organic layers are located on the side of the first substrate close to the array substrate. The sealant is located in the non-display region and located between the array substrate and the packaging cover plate to bond the array substrate and the packaging cover plate together. There is a spacer region between the organic layer closest to the sealant in the direction from the display region to the sealant among the plurality of organic layers and the sealant. The organic layer closest to the sealant is separated from the sealant by the spacer region, and the spacer region is located in the non-display region.

## Description

### TECHNICAL FIELD

At least one embodiments of the present disclosure relates to a display panel and a manufacturing method thereof, and a display apparatus.

### BACKGROUND

People pay more and more attention to Organic light-emitting diode (OLED) display technology. However, organic materials included in many organic light-emitting diode devices are sensitive to moisture and oxygen, and are not resistant to high temperature; in addition, the oxidation of metal electrodes of the organic light-emitting diode can degrade the performance of the organic light-emitting diode. Therefore, it is important to isolate the organic light-emitting diode from water and oxygen in the environment and to dissipate heat produced by the organic light-emitting diode device to extend the life of the organic light-emitting diode device. The organic light-emitting diode device is usually sealed by a sealant and an encapsulation cover plate, and a desiccant can also be used to prevent water vapor from entering the organic light-emitting diode device.

### SUMMARY

At least one embodiments of the present disclosure provides a display panel, the display panel comprises: an array substrate, an encapsulation cover plate and a plurality of organic layers. The array substrate comprises a display region and a non-display region surrounding at least a part of the display region, the display region comprises a plurality of pixels arranged in an array, each of the pixels comprises a plurality of sub-pixels, and each of the sub-pixels comprises a light-emitting device. The encapsulation cover plate is opposite to the array substrate, and comprises: a first base substrate and a plurality of organic layers on a side of the first base substrate close to the array substrate. The frame sealant is in the non-display region and between the array substrate and the encapsulation cover plate, and is configured to adhere the array substrate and the encapsulation cover plate; a gap region is between an organic layer of the plurality of the organic layers closest to the frame sealant in a direction from the display region to the frame sealant and the frame sealant, the gap region separates the organic layer of the plurality of the organic layers closest to the frame sealant from the frame sealant, and the gap region is in the non-display region.

For example, in the display panel provided by at least one embodiment of the disclosure, the plurality of the organic layers comprise a black matrix and a protection layer. The black matrix is on a side of the first base substrate close to the array substrate and defines a plurality of sub-color filter units, the plurality of the sub-color filter units are in one-to-one correspondence with the plurality of the sub-pixels, and the black matrix is configured to enable light emitted by the light-emitting device of each of the sub-pixels to pass through and exit from the corresponding sub-color filter unit; the protection layer covers a first surface of the black matrix away from the first base substrate and the plurality of the sub-color filter units, and the organic layer of the plurality of the organic layers closest to the frame sealant is the black matrix.

For example, in the display panel provided by at least one embodiment of the disclosure, the plurality of the organic layers comprise a black matrix and a protection layer. The black matrix is on a side of the first base substrate close to the array substrate and defines a plurality of sub-color filter units, the plurality of the sub-color filter units are in one-to-one correspondence with the plurality of the sub-pixels, and the black matrix is configured to enable light emitted by the light-emitting device of each of the sub-pixels to pass through and exit from the corresponding sub-color filter unit; the protection layer covers a first surface of the black matrix away from the first base substrate and a side surface of the black matrix intersecting with the first surface, and the organic layer of the plurality of the organic layers closest to the frame sealant is the protection layer.

For example, in the display panel provided by at least one embodiment of the disclosure, the plurality of the organic layers comprise a black matrix, a protection layer and a first spacer. The black matrix is on a side of the first base substrate close to the array substrate and defining a plurality of sub-color filter units, the plurality of the sub-color filter units are in one-to-one correspondence with the plurality of the sub-pixels, and the black matrix is configured to enable light emitted by the light-emitting device of each of the sub-pixels to pass through and exit from the corresponding sub-color filter unit; the protection layer covers at least a portion of the black matrix and the plurality of the sub-color filter units; the first spacer is on a side of the first base substrate close to the array substrate and on a side of both of the black matrix and the protection layer close to the frame sealant, and the organic layer of the plurality of the organic layers closest to the frame sealant is the first spacer.

For example, in the display panel provided by at least one embodiment of the disclosure, the larger a size of the non-display region in a transverse direction from the black matrix to the frame sealant, the larger a width of the gap region in the transverse direction.

For example, in the display panel provided by at least one embodiment of the disclosure, the larger a size of the non-display region in a transverse direction from the black matrix to the frame sealant, the smaller a width of the gap region in the transverse direction.

For example, in the display panel provided by at least one embodiment of the disclosure, a width of the gap region in a direction from the protection layer to the frame sealant is greater than or equal to 10µm.

For example, in the display panel provided by at least one embodiment of the disclosure, a width of the frame sealant in the transverse direction is less than or equal to 2 mm, and a width of the gap region is greater than or equal to 100µm.

For example, in the display panel provided by at least one embodiment of the disclosure, the protection layer is a planarization layer, and a surface of the planarization layer away from the first base substrate is a flat surface.

For example, in the display panel provided by at least one embodiment of the disclosure, the encapsulation cover plate further comprises an opaque light shielding layer on the first base substrate and covering at least a portion of the gap region.

For example, in the display panel provided by at least one embodiment of the disclosure, the light shielding layer covers an entirety of the gap region.

For example, in the display panel provided by at least one embodiment of the disclosure, the light shielding layer is on a side of the first base substrate close to the array substrate, and an orthographic projection of the light shielding layer on the first base substrate does not overlap with an orthographic projection of the frame sealant on the first base substrate.

For example, in the display panel provided by at least one embodiment of the disclosure, the light shielding layer is on a side of the first base substrate close to the array substrate, and an orthographic projection of the light shielding layer on the first base substrate at least partially overlaps with an orthographic projection of the frame sealant on the first base substrate.

For example, in the display panel provided by at least one embodiment of the disclosure, the light shielding layer is on a side of the first base substrate away from the array substrate, and an orthographic projection of the light shielding layer on the first base substrate at least partially overlaps with an orthographic projection of the frame sealant on the first base substrate.

For example, in the display panel provided by at least one embodiment of the disclosure, a material of the light shielding layer is a metal material.

For example, in the display panel provided by at least one embodiment of the disclosure, the array substrate further comprises a pixel definition layer defining the plurality of the sub-pixels; an orthographic projection of the black matrix on the first base substrate is within an orthographic projection of the pixel definition layer on the first base substrate.

For example, the display panel provided by at least one embodiment of the disclosure further comprises a second spacer. The second spacer is on a side of the pixel definition layer close to the black matrix, and a space is between the second spacer and the protection layer; an orthographic projection of the second spacer on the first base substrate is within the orthographic projection of the pixel definition layer on the first base substrate, and is within the orthographic projection of the black matrix on the first base substrate; a height of the second spacer in a direction perpendicular to the first base substrate is smaller than a height of the first spacer in the direction perpendicular to the first base substrate.

For example, the display panel provided by at least one embodiment of the disclosure further comprises a filling material layer which is filled between the array substrate and the encapsulation cover plate and comprises a first portion in the display region and a second portion in a frame region; the first portion covers the light-emitting device, and the second portion fills the gap region.

For example, the display panel provided by at least one embodiment of the disclosure, the filling material layer is an elastic layer, in the case that the display panel is applied with a pressure in a direction perpendicular to the first base substrate, a thickness of the elastic layer in a direction perpendicular to the first base substrate decreases.

At least one embodiment of the present disclosure further provides a display apparatus, the display apparatus comprises any one of the display panels provided by the embodiments of the present disclosure.

At least one embodiment of the present disclosure further provides a manufacturing method of a display panel, the manufacturing method comprises: providing an array substrate, in which the array substrate comprises a display region and a non-display region surrounding at least a part of the display region, the display region comprises a plurality of pixels arranged in an array, each of the pixels comprises a plurality of sub-pixels, and each of the sub-pixels comprises a light-emitting device; forming an encapsulation cover plate; forming a frame sealant, in which the frame sealant is located in the non-display region; and allowing the array substrate to be opposite to the encapsulation cover plate and bonding the array substrate with the encapsulation cover plate; forming the encapsulation cover plate comprises: providing a first base substrate; and forming a plurality of organic layers on a side of the first base substrate close to the array substrate. The frame sealant is located between the array substrate and the encapsulation cover plate, the frame sealant adheres the array substrate and the encapsulation cover plate, a gap region is provided between an organic layer of the plurality of the organic layers closest to the frame sealant in a direction from the display region to the frame sealant and the frame sealant, the gap region separates the organic layer of the plurality of the organic layers closest to the frame sealant from the frame sealant, and the gap region is located in the non-display region.

### BRIEF DESCRIPTION OF THE DRAWINGS

In order to clearly illustrate the technical solution of the embodiments of the present disclosure, the drawings of the embodiments will be briefly described. It is apparent that the described drawings are only related to some embodiments of the present disclosure and thus are not limitative of the present disclosure.
FIG 1 is a schematic planar diagram of a display panel provided by an embodiment of the present disclosure;
FIG 2 is a schematic cross-sectional diagram taken along the line A-A' in FIG 1;
FIG 3A is a schematic planar diagram of another display panel provided by an embodiment of the present disclosure;
FIG 3B is a schematic cross-sectional diagram taken along the line B-B' in Fig. 3A;
FIG 4A is a schematic planar diagram of still another display panel provided by an embodiment of the present disclosure;
FIG 4B is a schematic cross-sectional diagram taken along the line C-C' in FIG 4A;
FIG 5A is a schematic planar diagram of still another display panel provided by an embodiment of the present disclosure;
FIG 5B is a schematic cross-sectional diagram taken along the line D-D' in Fig. 5A;
FIG 6 is a schematic cross-sectional diagram of still another display panel provided by an embodiment of the present disclosure;
FIG 7 is a schematic cross-sectional diagram of still another display panel provided by an embodiment of the present disclosure; and
FIG 8 is a schematic diagram of a display apparatus provided by an embodiment of the present disclosure.

### DETAILED DESCRIPTION

In order to make objects, technical details and advantages of embodiments of the present disclosure clear, the technical solutions of the embodiments will be described in a clearly and fully understandable way in connection with the related drawings. It is apparent that the described embodiments are just a part but not all of the embodiments of the present disclosure. Based on the described embodiments herein, those skilled in the art can obtain, without any inventive work, other embodiment(s) which should be within the scope of the present disclosure.

Unless otherwise defined, all the technical and scientific terms used herein have the same meanings as commonly understood by one of ordinary skill in the art to which the present disclosure belongs. The terms "first," "second," etc., which are used in the description and claims of the present disclosure, are not intended to indicate any sequence, amount or importance, but distinguish various components. The terms "comprises," "comprising," "includes," "including," etc., are intended to specify that the elements or the objects stated before these terms encompass the elements or the objects listed after these terms as well as equivalents thereof, but do not exclude other elements or objects. The phrases "connect", "connected", etc., are not intended to define a physical connection or a mechanical connection, but may comprise an electrical connection which is direct or indirect. The terms "on," "under," "left," "right" and the like are only used to indicate relative position relationship, and in a case that the position of an object is described as being changed, the relative position relationship may be changed accordingly.

The dimensions of the drawings used in the present disclosure are not drawn strictly according to actual scale, the number of pixels in the display region is not limited to the number shown in the figure, and the specific size and quantity of each structure can be determined according to actual needs. The drawings described in this disclosure are only structural schematic diagrams.

At least one embodiment of the present disclosure provides a display panel, and the display panel includes: an array substrate, an encapsulation cover plate, and a frame sealant. The array substrate includes a display region and a non-display region surrounding at least a part of the display region, the display region comprises a plurality of pixels arranged in an array, each of the pixels comprises a plurality of sub-pixels, and each of the sub-pixels comprises a light-emitting device. The encapsulation cover plate is opposite to the array substrate, and comprises: a first base substrate and a plurality of organic layers on a side of the first base substrate close to the array substrate. The frame sealant is in the non-display region and between the array substrate and the encapsulation cover plate, and is configured to adhere the array substrate and the encapsulation cover plate; a gap region is between an organic layer of the plurality of the organic layers closest to the frame sealant in a direction from the display region to the frame sealant and the frame sealant, the gap region separates the organic layer of the plurality of the organic layers closest to the frame sealant from the frame sealant, and the gap region is in the non-display region. Especially in a large-size display panel, the plurality of the organic layers need to be arranged on the encapsulation cover plate, such as a color filter and a black matrix, to obtain a higher color gamut and a better color effect. However, the ability of the organic layers to block water and oxygen is weak (for example, relative to the inorganic layer), in the embodiments of the present disclosure, in the case that water and oxygen in an external environment enter the inside of the display panel, that is, after the water and the oxygen in the external environment enter a side of the frame sealant close to the display region, because the frame sealant is not in direct contact with the organic layer of the plurality of organic layers closest to the frame sealant, the water and oxygen entering the inside of the display panel will not directly enter the organic layer after passing through the frame sealant and diffuse to the light-emitting device through the organic layer, instead, the water and the oxygen are buffered in the gap region, for example, the water and the oxygen diffuse to other positions except positions that the organic layers are located in the gap region or are absorbed in the gap region, so as to better prevent the water and the oxygen in the external environment from entering the display region.

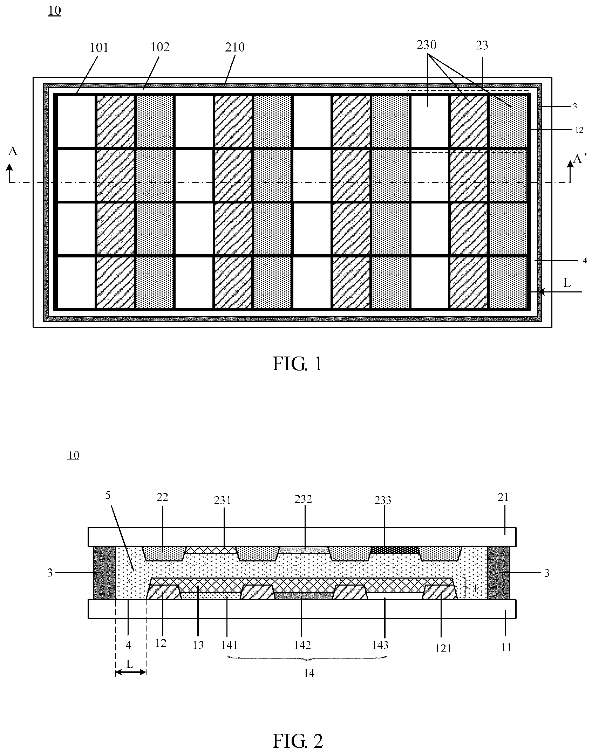

Exemplarily, FIG 1 is a schematic planar diagram of a display panel provided by an embodiment of the present disclosure, FIG 2 is a schematic cross-sectional diagram taken along the line A-A' in FIG 1, for example, FIG. 2 is a schematic cross-sectional diagram of the display panel shown in FIG. 1, for clarity and conciseness, FIG. 2 only shows a pixel in the display region.

As shown in FIG. 1 and FIG. 2, the display panel 10 includes: an array substrate, an encapsulation cover plate and a frame sealant 3; the array substrate includes a display region 101 and a non-display region 102 p surrounding at least a part of the display region 101, the display region 101 includes a plurality of pixels 23 arranged in an array, and each of the pixels 23 includes a plurality of sub-pixels 230. Each of the sub-pixels 230 includes a light-emitting device. For example, one pixel 23 includes a first sub-pixel, a second sub-pixel, and a third sub-pixel. The first sub-pixel, the second sub-pixel, and the third sub-pixel respectively include a first light-emitting device 231, a second light-emitting device 232, and a third light-emitting device 233. The first light-emitting device 231, the second light-emitting device 232 and the third light-emitting device 233 respectively emit light of different colors, such as red light, green light, and blue light, respectively. For example, in the embodiment of the present disclosure, the case that one pixel 23 includes three sub-pixels 230 is taken as an example, in some other embodiments, the number of the sub-pixels of one pixel is not limited to three, the embodiment of the present disclosure does not limit this.

For example, a plane shape of the frame sealant 3 is a closed ring, so as to better play a role in bonding and blocking water and oxygen.

For example, the light-emitting device is a light-emitting diode (LED) device, such as an organic light-emitting diode (OLED) device. For example, the light-emitting device includes a first electrode, a light-emitting layer, and a second electrode that are stacked arranged in a direction perpendicular to the second base substrate 21. For example, the first electrode is an anode and the second electrode is a cathode. For example, an OLED device further includes a hole injection layer, a hole transport layer, an electron injection layer, and an electron transport layer, for these structures, those skilled in the art can design with reference to conventional techniques, which will not be repeated herein.

The encapsulation cover plate is opposite to the array substrate. The encapsulation cover plate includes a first base substrate 11 and a plurality of organic layers 1. The array substrate includes a second base substrate 21 opposite to the first base substrate 11. The plurality of the organic layers 1 are located on a side of the first base substrate 11 close to the array substrate. The frame sealant 3 is located in the non-display region 102 and is located between the array substrate and the encapsulation cover plate, and the frame sealant 3 adheres the array substrate and the encapsulation cover plate. For example, the frame sealant 3 is located in the non-display region 102 and is located between the first base substrate 11 and the second substrate 21, and the frame sealant 3 adheres the first base substrate 11 and the second substrate 21.

For example, the plurality of the organic layers include a black matrix 12 and a protection layer 13. The black matrix 12 is located on a side of the first base substrate 11 close to the array substrate, and the black matrix 12 defines a plurality of sub-color filter units 14, the plurality of the sub-color filter units 14 are in one-to-one correspondence with the plurality of the sub-pixels 230, and the black matrix 12 is configured to enable light emitted by the light-emitting device of each of the sub-pixels 230 to pass through and exit from the corresponding sub-color filter unit 14. The protection layer 13 covers a first surface of the black matrix 12 away from the first base substrate 11 and the plurality of the sub-color filter units 14. In the embodiment, the organic layer closest to the frame sealant 3 is the black matrix 12. That is, a gap region 4 is provided between the black matrix 12 and the frame sealant 3, the gap region 4 separates the black matrix 12 from the frame sealant 3, and the gap region 4 is located in the non-display region 102. Because the frame sealant 3 is not in direct contact with the black matrix 12, the water and the oxygen entering the inside of the display panel 10 will not directly enter the black matrix 12 after passing through the frame sealant 3 and diffuse to the light-emitting device by the black matrix 12, instead, the water and the oxygen are buffered in the gap region 4, for example, the water and the oxygen diffuse to other positions except the positions that the organic layers 1 are located in the gap region 4 or are absorbed, moreover, a propagation path of the water and oxygen to the light-emitting device is increased, so as to better prevent the water and the oxygen in the external environment from entering the display region. Especially for the large-size display panel, the effect of blocking the water and the oxygen is more prominent. For example a size of the large-sized panel is larger than 48 inches.

For example, a filter unit includes a plurality of sub-color filter units 14, for example, the filter unit includes a red filter unit, a green filter unit, and a blue filter unit that respectively correspond to the first light-emitting device 231, the second light-emitting device 232, and the third light-emitting device 233. The red filter unit, the green filter unit and the blue filter unit respectively include a red filter layer, a green filter layer and a blue filter layer. For example, a thickness of the red filter layer, a thickness of the green filter layer and a thickness of the blue filter layer in a direction perpendicular to the first base substrate 11 are all in a range of 0.1 µm to 5 µm, all of a material of the red filter layer, a material of the green filter layer and a material of the blue filter layer include a resin material, for example, the resin material is a photoresist material. The embodiment of the present disclosure does not limit the material of the color filter layer.

For example, the black matrix 12 surrounds each of the color filter layers, that is, the black matrix 12 surrounds each of the red filter layers, each of the green filter layers, and each of the blue filter layers to prevent crosstalk between light of different colors. Especially in the large-size display panel, it is required to arrange the black matrix 12 and the plurality of the sub-color filter units 14 on the encapsulation cover plate, to obtain a higher color gamut and a better color effect.

A direction from the black matrix 12 to the frame sealant 3 is a transverse direction. For example, a width L of the gap region 4 in the transverse direction is proportional to a size of the non-display region 102 in the transverse direction. The larger the size of the non-display region 102 in the transverse direction, the larger the width L of the gap region 4 is. In this way, the width L of the gap region 4 can be designed according to the size of the non-display region 102 in the transverse direction, that is, a width of a frame region, so that the width L of the gap region 4 matches the width of the frame region, and the frame cannot be excessively widened because of the gap region 4.

For example, the width L of the spacer region 4 in the transverse direction is inversely proportional to a size of the frame sealant 3 in the transverse direction. The larger the size of the frame sealant 3 in the transverse direction, the smaller the width L of the gap region 4 is. The larger the size of the frame sealant 3 in the transverse direction, the stronger the ability of the frame sealant 3 of blocking water and oxygen, so that the width L of the gap region 4 is reduced, the frame sealant 3 and the gap region 4 can reasonably allocate the width of the frame region, and the frame cannot be excessively widened because of the gap region 4.

For example, the width of the gap region 4 in a direction from the protection layer 13 to the frame sealant 3 is greater than or equal to 10 µm to achieve a better effect of blocking water and oxygen.

For example, in the case that the width of the frame sealant 3 in the transverse direction is less than or equal to 2 mm, the width L of the gap region 4 is greater than or equal to 100 µm.

It should be noted that, the above dimensions are only exemplary, those skilled in the art can design the width L of the gap region 4 according to the size of the frame, the width of the frame sealant, and the requirements for blocking water and oxygen, the embodiment of the present disclosure does not specifically limit the width L of the gap region 4.

For example, a thickness of the black matrix 12 in the direction perpendicular to the first base substrate 11 is in a range of 0.1 µm to 5 µm. For example, a material of the black matrix 12 is a photoresist material, so as to form a pattern of the black matrix 12 by a photolithography process. For example, the material of the black matrix 12 is a negative photoresist, of course, the material of the black matrix 12 may also be a positive photoresist.

As shown in FIG. 2, for example, the protection layer 13 is a planarization layer, a surface of the planarization layer away from the first base substrate 11 is a flat surface. Thereby, a filling material filled on the planarization layer can be pressed to be flatter, so that the encapsulation cover plate and the array substrate are pressed more closely together, and the sealing performance of the light-emitting device is enhanced.

For example, a thickness of the planarization layer 13 in the direction perpendicular to the first base substrate 11 is in a range of 0.1µm to 5µm. For example, a material of the planarization layer is a resin, or a positive photoresist or a negative photoresist.

As shown in FIG. 2, for example, the array substrate further includes a pixel definition layer 22. The pixel definition layer 22 defines a plurality of sub-pixels 23. For example, an orthographic projection of the black matrix 12 on the first base substrate 11 is within an orthographic projection of the pixel definition layer 22 on the first base substrate 11, in this way, a size of a sub-color filter unit (aperture) is greater than or equal to a size of the corresponding sub-pixel (aperture) to ensure the luminous efficiency.

As shown in FIG. 2, for example, the display panel 10 further includes a filling material layer 5. The filling material layer 5 is filled between the array substrate and the encapsulation cover plate, and the filling material layer 5 includes a first portion located in the display region 101 and a second portion located in the frame region. The first portion covers the light-emitting device, and the second portion fills the spacer region 4. In this way, the water and oxygen entering the inside of the display panel 10 can diffuse to the filling material layer 5 in the gap region 4, and the water and oxygen is absorbed by the filling material layer 5, so as to better prevent the water and the oxygen in the external environment from entering the display region.

For example, a material of the filling material layer 5 includes resin, such as acrylic, epoxy and so on. For example, in some embodiments, the filling material layer 5 further includes at least one selected from a group consisting of a desiccant, an oxygen absorbent, and a heat dissipation material to achieve a more effective effect of blocking water and oxygen and a more effective of dissipating heat. For example, the desiccant is quicklime (CaO) or water-absorbing resin; the oxygen absorbent is an inorganic oxygen absorbent, such as a metal powder (including iron powder, copper powder and so on), a mixture of sodium sulfide and iron powder, or sodium disulfite and so on, the oxygen absorbent can also be an organic oxygen absorbent, such as butylated hydroxymethyl anisole (BHA) or bishydroxymethyl ether (BHT), etc.; for example, the heat dissipation material is heat conducting lipids, such as heat-dissipating particles made of zinc oxide, aluminum oxide, or boron nitride. Of course, in the embodiment, the material of the filling material layer 5 is not limited to the above-mentioned desiccant, oxygen absorbent and heat dissipation material, the material can also contain other materials that are beneficial to protecting the organic light-emitting device, and the above three materials are not limited to the listed types, which are not limited in the present disclosure. For example, in some embodiments, the filling material layer 5 does not include the desiccant, the oxygen absorbent and the heat dissipation material. The embodiment of the present disclosure does not limit the filling material layer 5.

For example, the filling material layer 5 is an elastic layer, in the case where the display panel 10 is applied with pressure in a direction perpendicular to the first base substrate 11, a thickness of the elastic layer in the direction perpendicular to the first base substrate 11 is reduced. For example, the Young's modulus of the filling material layer 5 is in a range of about 0.1 MPa to about 10 MPa. The Young's modulus is a physical quantity that characterizes the ability of a material to resist tension or compression within the elastic limit. If the Young's modulus of the filling material layer 5 is less than about 0.1 MPa, a relatively large pressure is required to deform the filling material layer 5, which greatly reduces the buffering effect of the filling material layer 5; if the Young's modulus is greater than about 10 MPa, the elastic layer 15 is too soft, which reduces the durability of the display panel 10.

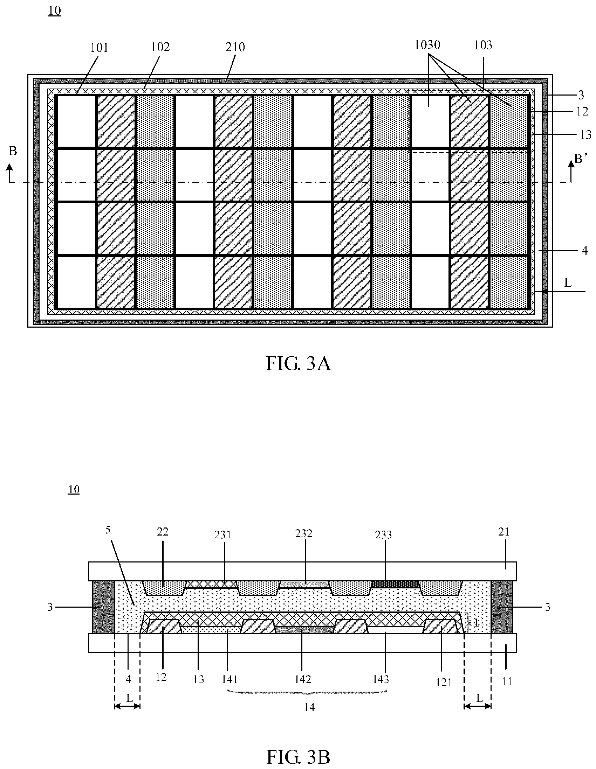

For example, FIG. 3A is a schematic planar diagram of another display panel provided by an embodiment of the present disclosure, FIG 3B is a schematic cross-sectional diagram taken along the line B-B' in Fig. 3A. The embodiment shown in FIG. 3A and FIG. 3B has the following differences from the embodiment shown in FIG. 2. As shown in FIG. 3A and FIG. 3B, the protection layer 13 covers a first surface of the black matrix 12 away from the first base substrate 11 and a side surface of the black matrix 12 that intersects with the first surface, among the plurality of the organic layers 1, the organic layer closest to the frame sealant 3 in the transverse direction is the protection layer 13. Therefore, the water and the oxygen that enter the inside of the display panel 10 will not directly enter the protection layer 13 after passing through the frame sealant 3 and then diffuse to the light-emitting device through the protection layer 13, instead, the water and the oxygen care buffered in the gap region 4, for example, c is absorbed to other positions except the position of the organic layer 1 in the gap region 4 or are absorbed in the gap region 4, moreover, the propagation path of the water and oxygen to the light-emitting device is increased, so as to better prevent the water and the oxygen in the external environment from entering the display region. The other features and corresponding technical effects of the embodiment shown in FIG. 3B are the same as the other features and corresponding technical effects of the embodiment shown in FIG. 2, please refer to the previous descriptions.

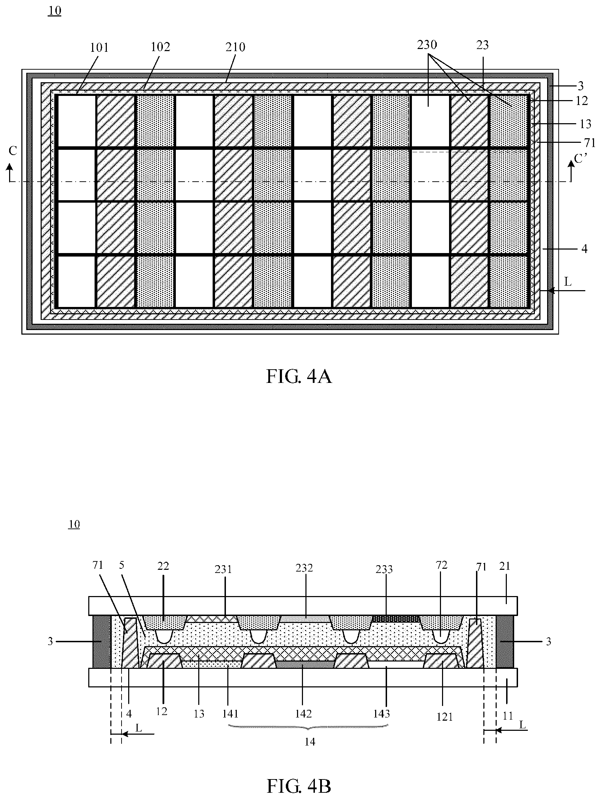

For example, FIG. 4A is a schematic planar diagram of still another display panel provided by an embodiment of the present disclosure. FIG. 4B is a schematic cross-sectional diagram taken along the line C-C' in FIG. 4A. The embodiment shown in FIG. 4A and FIG. 4B has the following differences from the embodiment shown in FIG. 2. As shown in FIG. 4A and FIG. 4B, in addition to the black matrix 12 and the protection layer 13, the plurality of the organic layers further include a first spacer 71. The first spacer 71 is located on a side of the first base substrate 11 close to the array substrate, and the first spacer 71 is located on a side of both the black matrix 12 and the protection layer 13 close to the frame sealant 3, the organic layer that is closest to the frame sealant 3 of the plurality of the organic layers is the first spacer 71. Therefore, the water and the oxygen that enter the inside of the display panel 10 will not directly enter the first spacer 71 after passing through the frame sealant 3 and then diffuse to the light-emitting device through the first spacer 71, instead, the water and the oxygen are buffered in the gap region 4, for example, the water and the oxygen diffuse to other positions except positions that the organic layers 1 are located in the gap region 4 or are absorbed in the gap region 4, moreover, a propagation path of the water and oxygen to the light-emitting device is increased, so as to better prevent the water and oxygen in the external environment from entering the display region.

For example, an end of the first spacer 71 away from the second base substrate 21 is in contact with the first base substrate 11, a gap is between an end of the first spacer 71 away from the first base substrate 11 and the second base substrate 21, the first spacer 71 is supported between the first base substrate 11 and the second base substrate 21 to play a role of maintaining a stable distance between the first base substrate 11 and the second base substrate 21, at the same time, the first spacer 71 can block water and oxygen in the direction perpendicular to the first base substrate 11 from further entering the display region inside the first spacer 71, compared with the display panel without arranging the first spacer 71, the display panel 10 has a better effect of preventing water and oxygen from entering the display region. For example, in other embodiments, the end of the first spacer 71 away from the first base substrate 11 is in contact with the second base substrate 21.

For example, in the embodiment shown in FIG. 4A and FIG. 4B, a plane shape of the first spacer 71 is a closed ring, so as to achieve a better supporting effect and an effect of blocking water and oxygen at an edge of the entire display region. Of course, in other embodiments, the first spacer 71 includes a plurality of pillars spaced apart from each other.

As shown in FIG. 4B, for example, the display panel 10 further includes a second spacer 72. The second spacer 72 is located on a side of the pixel definition layer 22 close to the black matrix 12, and a gap is provided between the protection layer 13 and the second spacer 72; an orthographic projection of the second spacer 72 on the first base substrate 11 is within an orthographic projection of the pixel definition layer 22 on the first base substrate 11, and the orthographic projection of the second spacer 72 on the first base substrate 11 is located in the orthographic projection of the black matrix 12 on the first base substrate 11. In the case that the display panel 10 is under an external pressure, the second spacer 72 can maintain a relatively stable distance between the first base substrate 11 and the second substrate 21; at the same time, the second spacer 72 cannot affect an aperture ratio of the display panel 10.

For example, a height of the second spacer 72 in the direction perpendicular to the first base substrate 11 is smaller than a height of the first spacer 71 in the direction perpendicular to the first base substrate 11.

For example, a material of the second spacer and a material of the first spacer include a resin, a positive photoresist or a negative photoresist to simplify the photolithography process in the process of patterning the second spacer and the first spacer by the photolithography patterning.

The other features and corresponding technical effects of the embodiment shown in FIG. 4B are the same as the other features and corresponding technical effects of the embodiment shown in FIG. 3B, please refer to the previous description.

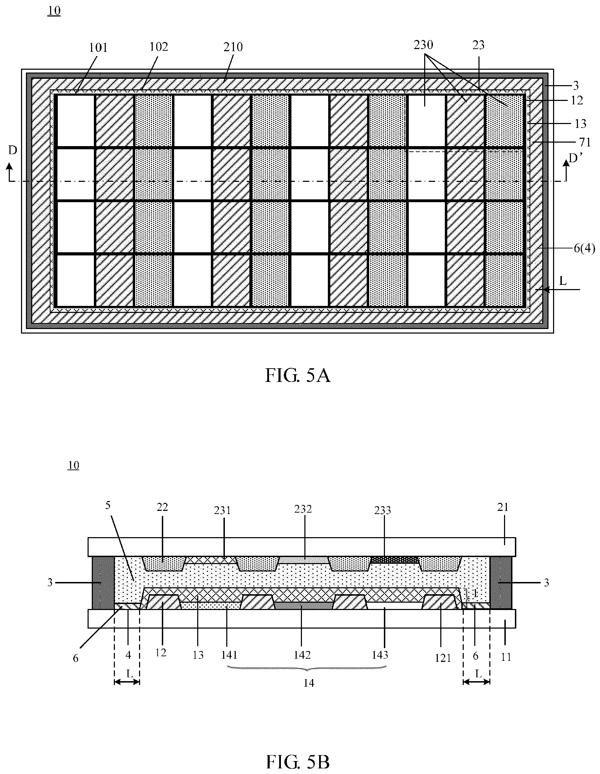

For example, FIG. 5A is a schematic planar diagram of still another display panel provided by an embodiment of the present disclosure, FIG. 5B is a schematic cross-sectional diagram taken along the line D-D' in Fig. 5A. The embodiment shown in FIG. 5A and FIG. 5B have the following differences from the embodiment shown in FIG. 3B. As shown in FIG. 5A and FIG. 5B, the encapsulation cover plate further includes an opaque light-shielding layer 6. The opaque light shielding layer 6 is located on the first base substrate 11, and the opaque light shielding layer 6 covers at least a portion of the gap region 4 to block the light leakage of the display panel in the gap region 4, moreover, the light shielding layer 6 further blocks the water and the oxygen. For example, the light shielding layer covers the entire gap region 4 to better play a role of shielding light and blocking water and oxygen.

For example, a planar shape of the light shielding layer 6 is a closed ring to achieve a better shielding effect and a better effect of blocking water and oxygen at the edge of the entire display region.

For example, a material of the light shielding layer 6 is a metal material. The metal material is, for example, metal or alloy, such as molybdenum, copper, aluminum, chromium, nickel, or their alloys. Of course, the above-listed metal materials are only exemplary and are not limited to the above-listed types. The metal material has a stronger ability to block water and oxygen, for example, has a stronger ability to block water and oxygen than the organic opaque material, and the metal material is beneficial to obtain a better effect of blocking water and oxygen. Of course, in some embodiments, the material of the light-shielding layer 6 may also be an organic material, such as a light-shielding tape.

For example, as shown in FIG. 5B, the light shielding layer 6 is located on a side of the first base substrate 11 close to the array substrate, an orthographic projection of the light shielding layer 6 on the first base substrate 11 does not overlap with an orthographic projection of the frame sealant 3 on the first base substrate 11. As a result, the frame sealant 3 is in direct contact with the first base substrate 11 and has a stronger adhesion to the first base substrate 11 and the second substrate 21, and prevents the light shielding layer 6 from overlapping with the frame sealant 3, thereby avoiding reducing the adhesion of the frame sealant 3 to the first base substrate 11 and the second base substrate 21.

In some embodiments, a first side surface of the light shielding layer 6, that is, a surface of the light shielding layer 6 close to the frame sealant 3, is in contact with a first side surface of the frame sealant 3, that is, the surface close to the light shielding layer 6, or, a certain gap is between the first side surface of the light shielding layer 6 and the first side surface of the frame sealant 3, so as to further effectively prevent water and oxygen from entering the display region using the gap. In some embodiments, the filling material layer 5 is provided in the gap to further effectively use the filling material layer 5 in the gap to prevent water and oxygen from entering the display region.

In some embodiments, a second side surface of the light-shielding layer 6 opposite to the first side surface, that is, the surface of the light-shielding layer 6 away from the frame sealant 3, is in contact with a first side surface of the protection layer 13, that is, the surface close to the frame sealant 3, or, a certain gap is between the second side surface and the first side surface of the protection layer 13 to further effectively prevent water and oxygen from entering the display region using the gap. In some embodiments, the filling material layer 5 is provided in the gap to further effectively use the filling material layer 5 in the gap to prevent water and oxygen from entering the display region.

The other features and corresponding technical effects of the embodiment shown in FIG. 5B are the same as those illustrated in FIG. 3B, please refer to the previous description.

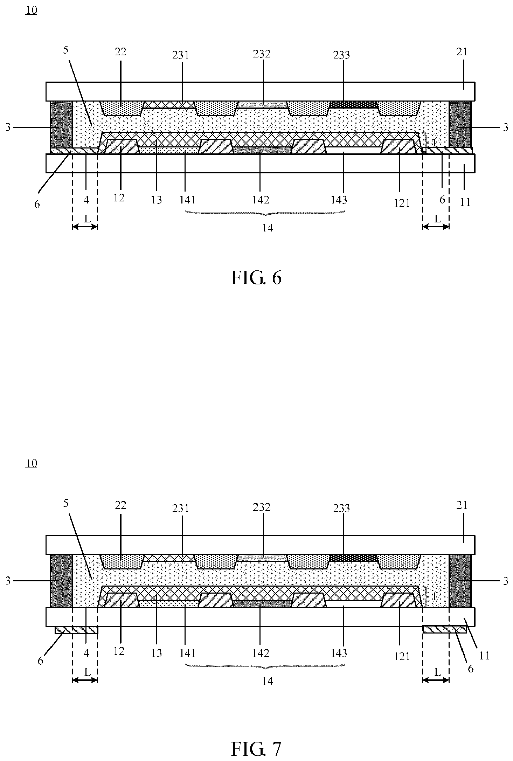

For example, FIG. 6 is a schematic cross-sectional diagram of still another display panel provided by an embodiment of the present disclosure. The embodiment shown in FIG. 6 has the following differences from the embodiment shown in FIG. 5B. As shown in FIG. 6, the orthographic projection of the light shielding layer 6 on the first base substrate 11 at least partially overlaps with the orthographic projection of the sealant 3 on the first base substrate 11, for example, the light shielding layer 6 extends outward from the gap region 4 to be stacked with the frame sealant 3. For example, in some embodiments, the frame sealant 3 is transparent, and the light-shielding layer 6 shown in FIG. 6 can achieve a better light-shielding effect.

In some embodiments, a second side surface of the light-shielding layer 6 opposite to the first side surface, that is, the surface of the light-shielding layer 6 away from the frame sealant 3, is in contact with a first side surface of the protection layer 13, that is, the surface close to the frame sealant 3, a certain gap is between second side surface of the light-shielding layer 6 opposite to the first side surface and the first side surface of the protection layer 13 to further effectively prevent water and oxygen from entering the display region using the gap. In some embodiments, the filling material layer 5 is provided in the gap to further effectively prevent water and oxygen from entering the display region using the filling material layer 5 in the gap.

The other features and corresponding technical effects of the embodiment shown in FIG. 6 are the same as those illustrated in FIG. 5B, please refer to the previous description.

For example, FIG. 7 is a schematic cross-sectional diagram of still another display panel provided by an embodiment of the present disclosure. The embodiment shown in FIG. 7 has the following differences from the embodiment shown in FIG. 6. As shown in FIG. 7, the light-shielding layer 6 is located on the side of the first base substrate 11 away from the array substrate, and the orthographic projection of the light shielding layer 6 on the first base substrate 11 at least partially overlaps with the orthographic projection of the frame sealant 3 on the first base substrate 11. For example, in FIG. 7, the orthographic projection of the light shielding layer 6 on the first base substrate 11 partially overlaps with the orthographic projection of the frame sealant 3 on the first base substrate 11, or in other embodiments, the orthographic projection of the light shielding layer 6 on the first base substrate 11 overlaps with the entire orthographic projection of the frame sealant 3 on the first base substrate 11. The embodiment shown in FIG. 7 and the embodiment shown in FIG. 6 have the same or similar technical effects, and the related previous description can be referred to, which will not be repeated herein.

At least one embodiment of the present disclosure provides a display apparatus, and the display apparatus includes any one of the display panels provided by the embodiments of the present disclosure.

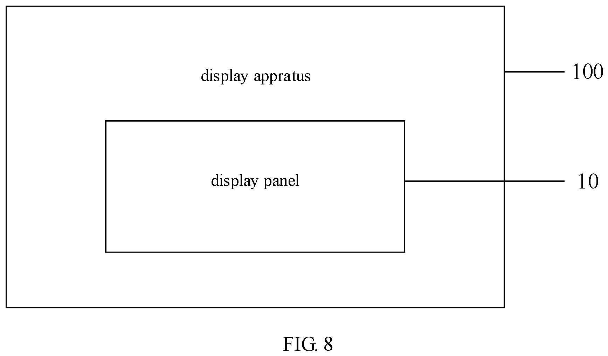

Exemplarily, FIG. 8 is a schematic diagram of a display apparatus provided by an embodiment of the present disclosure. As shown in FIG. 8, at least one embodiment of the present disclosure provides a display apparatus 100 including any one the display panels 10 provided by the embodiments of the present disclosure.

For example, other structures of the display apparatus 100, such as a pixel driving circuit, etc., can be designed with reference to conventional technologies in the art, which are not limited in the embodiments of the present disclosure.

For example, the display apparatus is a light-emitting diode display (LED) device, such as an organic light-emitting diode (OLED) display apparatus. For example, the display apparatus can be implemented as a product such as a mobile phone, a tablet computer, a monitor, a notebook computer, and an ATM machine.

At least one embodiment of the present disclosure further provides a manufacturing method of a display panel. The manufacturing method includes: providing an array substrate, in which the array substrate comprises a display region and a non-display region surrounding at least a part of the display region, the display region comprises a plurality of pixels arranged in an array, each of the pixels comprises a plurality of sub-pixels, and each of the sub-pixels comprises a light-emitting device; forming an encapsulation cover plate; forming a frame sealant, in which the frame sealant is located in the non-display region; and allowing the array substrate to be opposite to the encapsulation cover plate and bonding the array substrate with the encapsulation cover plate, in which forming the encapsulation cover plate comprises: providing a first base substrate; and forming a plurality of organic layers on a side of the first base substrate close to the array substrate; the frame sealant is located between the array substrate and the encapsulation cover plate, the frame sealant adheres the array substrate and the encapsulation cover plate, a gap region is provided between an organic layer of the plurality of the organic layers closest to the frame sealant in a direction from the display region to the frame sealant and the frame sealant, the gap region separates the organic layer closest to the frame sealant from the frame sealant, and the gap region is located in the non-display region.

Exemplarily, the manufacturing method includes the following steps.
Step 1: providing an array substrate; as shown in FIG. 1, the array substrate includes a display region 101 and a non-display region 102 surrounding at least a part of the display region, the display region 101 includes a plurality of pixels 23 arranged in an array, each of the pixels 23 includes a plurality of sub-pixels 230, and each of the sub-pixels includes a light-emitting device.
Step 2: forming an encapsulation cover plate; referring to FIG. 2, forming the encapsulation cover plate includes: providing a first base substrate 11; and forming a plurality of organic layers 1 on the first side of the first base substrate 11. The forming a plurality of the organic layers 1 includes sequentially forming a plurality of sub-color filter units 1, a black matrix 12, and a protection layer 13. For example, forming the plurality of the sub-color filter units 14 includes forming a red filter layer, a green filter layer, and a blue filter layer by a patterning process. The patterning process is, for example, a photolithography process. For example, all of a material of the red filter layer, a material of the green filter layer and a material of the blue filter layer include a resin material, for example, the resin material is a photoresist material. For example, the black matrix 12 is located on a side of the first base substrate 11 close to the array substrate, and the black matrix 12 defines a plurality of sub-color filter units 14, the plurality of the sub-color filter units 14 are in one-to-one correspondence with the plurality of sub-pixels 230, and the black matrix 12 is configured to enable light emitted by the light-emitting device of each of the sub-pixels 230 to pass through and exit from the corresponding sub-color filter unit 14. The protection layer 13 covers a first surface of the black matrix 12 away from the first base substrate 11 and the plurality of the sub-color filter units 14.
Step 3: forming a frame sealant 3 on the first side of the first base substrate 11. The frame sealant 3 is located in the non-display region 102, and a planar shape of the frame sealant 3 is a closed ring surrounding the display region.
Step 4: forming a filling material on the first side of the first base substrate 11, and the filling material is located inside the frame sealant 3 (located on a side of the frame sealant 3 close to the display region 101). For example, the filling material is formed in the frame sealant 3 by a dot coating method.
Step 5: before allowing the array substrate to be opposite the encapsulation cover plate and bonding the array substrate with the encapsulation cover plate, semi-curing the filling material and the frame sealant to reduce the fluidity of the filling material and the frame sealant.
Step 6: allowing the array substrate to be opposite the encapsulation cover plate and bonding the array substrate with the encapsulation cover plate, in which the frame sealant 3 is located between the array substrate and the encapsulation cover plate, the frame sealant adheres the array substrate and the encapsulation cover plate, and the first side of the first base substrate 11 is located on a side of the first base substrate 11 close to the array substrate; among the plurality of organic layers 1, the organic layer closest to the frame sealant in the direction from the display region to the frame sealant is the black matrix 12, a gap region 4 is provided between the black matrix 12 and the frame sealant 3, the gap region 4 separates the black matrix 12 and the frame sealant 3, and the gap region 4 is located in the non-display region 102.
Step 7: after allowing the array substrate to be opposite to the encapsulation cover plate and bonding the array substrate with the encapsulation cover plate, curing the filling material and the frame sealant 3 completely to obtain the filling material layer 5, so as to realize the stable combination of the array substrate and the encapsulation cover plate. The filling material layer 5 is filled between the array substrate and the encapsulation cover plate, and includes a first portion located in the display region 101 and a second portion located in the frame region. The first portion covers the light-emitting device, and the second portion fills the gap region 4.

For example, both the material of the filling material and the material of the frame sealant 3 include an ultraviolet curing resin, and the curing of the filling material and the frame sealant 3 may be realized by an ultraviolet curing method. Therefore, the display panel 10 shown in FIG 2 is obtained.

The manufacturing method of the display panel shown in FIG 3B differs from the manufacturing method of the display panel shown in FIG. 2 in that the protection layer 13 is formed to cover a first surface of the black matrix 12 away from the first base substrate 11 and a side surface of the black matrix 12 intersecting with the first surface, the organic layer of the plurality of organic layers 1 closest to the frame sealant 3 in the transverse direction is the protection layer 13. The other steps and features of the manufacturing method of the display panel shown in FIG. 3B are the same as the manufacturing method of the display panel shown in FIG. 2, and the previous description can be referred to.

The manufacturing method of the display panel shown in FIG 4B differs from the manufacturing method of the display panel shown in FIG. 2 in that the manufacturing method of the display panel shown in FIG. 4B further includes: before allowing the array substrate to be opposite to the encapsulation cover plate and bonding the array substrate with the encapsulation cover plate, a first spacer 71 is formed on the first side of the first base substrate 11. The first spacer 71 is located on the side of the first base substrate 11 close to the array substrate, and is located on the side of both the black matrix 12 and the protection layer 13 close to the frame sealant 3, and among the plurality of the organic layers, the organic layer closest to the frame sealant 3 is the first spacer 71. After allowing the array substrate to be opposite to the encapsulation cover plate and bonding the array substrate with the encapsulation cover plate, for example, the end of the first spacer 71 away from the second base substrate 21 is in contact with the first base substrate 11, a gap is formed between the end of the first spacer 71 away from the first base substrate 11 and the second base substrate 21. In addition, the array substrate further includes a second spacer 72. The second spacer 72 is located on a side of the pixel definition layer 22 close to the black matrix 12, and a gap is provided between the protection layer 13 and the second spacer 72; the orthographic projection of the second spacer 72 on the first base substrate 11 is within the orthographic projection of the pixel definition layer 22 on the first base substrate 11, and the orthographic projection of the second spacer 72 on the first base substrate 11 is within the orthographic projection of the black matrix 12 on the first base substrate 11. The other steps and features of the manufacturing method of the display panel shown in FIG 4B are the same as those of the display panel shown in FIG. 2, and the previous description can be referred to.

For example, both a material of the second spacer and a material of the first spacer include a resin, or a positive photoresist or a negative photoresist to simplify the photolithography process in the process of patterning the second spacer and the first spacer by the photolithography patterning.

The manufacturing method of the display panel shown in FIG 5B differs from the manufacturing method of the display panel shown in FIG. 2 in that the manufacturing method of the display panel shown in FIG. 5B further includes: before allowing the array substrate to be opposite to the encapsulation cover plate and bonding the array substrate with the encapsulation cover plate, forming an opaque light shielding layer 6 on the first side of the first base substrate 11. The opaque light shielding layer 6 is located on the first base substrate 11, and the opaque light shielding layer 6 covers at least a portion of the gap region 4 to block the light leakage of the display panel in the gap region 4, moreover, the light shielding layer 6 can further block water and oxygen. For example, the light shielding layer covers the entire gap region 4 to better play the role of shielding light and blocking water and oxygen. The light shielding layer 6 is located on the side of the first base substrate 11 close to the array substrate, and the orthographic projection of the light shielding layer 6 on the first base substrate 11 does not overlap with an orthographic projection of the frame sealant 3 on the first base substrate 11.

For example, a material of the light shielding layer 6 is a metal material. The metal material is, for example, metal or alloy, such as molybdenum, copper, aluminum, chromium, nickel, or their alloys. Of course, the above metal materials are only exemplary and are not limited to the above-listed types. The pattern of the light shielding layer 6 is formed by a method of screen printing or photolithography. For example, the material of the light-shielding layer 6 is an organic material, such as a light-shielding tape, in this case, in addition to the method of screen printing and photolithography, the pattern of the light-shielding layer 6 may be formed by a method of embossing, such as a roll-to-roll method.

In some embodiments, a first side surface of the light shielding layer 6, that is, a surface of the light shielding layer 6 close to the frame sealant 3, is in contact with a first side surface of the frame sealant 3, that is, a surface of the frame sealant 3 close to the light shielding layer 6, or, a certain gap is between the first side surface of the light shielding layer 6 and the first side surface of the frame sealant 3 to further effectively prevent water and oxygen from entering the display region using the gap. In some embodiments, the filling material layer 5 is provided in the gap to further effectively prevent water and oxygen from entering the display region using the filling material layer 5 in the gap.

In some embodiments, a second side surface of the light-shielding layer 6 opposite to the first side surface, that is, a surface of the light-shielding layer 6 away from the frame sealant 3, is in contact with a first side surface of the protection layer 13, that is, a surface of the protection layer 13 close to the frame sealant 3, or, a certain gap is between the second side surface of the light-shielding layer 6 opposite to the first side surface and the first side surface of the protection layer 13 to further effectively prevent water and oxygen from entering the display region using the gap. In some embodiments, the filling material layer 5 is provided in the gap to further effectively prevent water and oxygen from entering the display region using the filling material layer 5 in the gap.

The other steps and features of the manufacturing method of the display panel shown in FIG. 5B are the same as those of the display panel shown in FIG 2, and the previous description can be referred to.

The manufacturing method of the display panel shown in FIG 6 differs from the manufacturing method of the display panel shown in FIG. 5B in that the orthographic projection of the light shielding layer 6 on the first base substrate 11 at least partially overlaps with the orthographic projection of the sealant 3 on the first base substrate 11, for example, the light shielding layer 6 extends outward from the gap region 4 to be stacked with the frame sealant 3.

In some embodiments, a second side surface of the light-shielding layer 6 opposite to the first side surface, that is, the surface of the light-shielding layer 6 away from the frame sealant 3, is in contact with a first side surface of the protection layer 13, that is, the surface of the protection layer 13 close to the frame sealant 3, or, a certain gap is existed between second side surface of the light-shielding layer 6 opposite to the first side surface and the first side surface of the protection layer 13 to further effectively prevent water and oxygen from entering the display region using the gap. In some embodiments, the filling material layer 5 is provided in the gap to further effectively prevent water and oxygen from entering the display region using the filling material layer 5 in the gap. The other steps and features of the manufacturing method of the display panel shown in FIG. 6 are the same as those of the display panel shown in FIG. 5B, and the previous description can be referred to.

The manufacturing method of the display panel shown in FIG 7 differs from the manufacturing method of the display panel shown in FIG. 6 in that the manufacturing method of the display panel shown in FIG. 7 includes: before allowing the array substrate to be opposite to the encapsulation cover plate and bonding the array substrate with the encapsulation cover plate, a light shielding layer 6 is formed on the second side of the first base substrate 11 opposite to the first side of the first base substrate 11, and after allowing the array substrate to be opposite to the encapsulation cover plate and bonding the array substrate with the encapsulation cover plate, allowing the second side of the first base substrate 11 to be located on the side of the first base substrate 11 away from the array substrate. The orthographic projection of the light shielding layer 6 on the first base substrate 11 at least partially overlaps with the orthographic projection of the frame sealant 3 on the first base substrate 11. For example, in FIG. 7, the orthographic projection of the light shielding layer 6 on the first base substrate 11 partially overlaps with the orthographic projection of the frame sealant 3 on the first base substrate 11, or in other embodiments, the orthographic projection of the light shielding layer 6 on the first base substrate 11 overlaps the entire orthographic projection of the frame sealant 3 on the first base substrate 11. The other steps and features of the manufacturing method of the display panel shown in FIG. 7 are the same as those of the display panel shown in FIG 6, and the previous description can be referred to.

What are described above is related to only the illustrative embodiments of the present disclosure and not limitative to the protection scope of the present application. Therefore, the protection scope of the present application shall be defined by the accompanying claims.

## Claims

1. A display panel, comprising:
an array substrate comprising a display region and a non-display region surrounding at least a part of the display region, wherein the display region comprises a plurality of pixels arranged in an array, each of the pixels comprises a plurality of sub-pixels, and each of the sub-pixels comprises a light-emitting device;
an encapsulation cover plate opposite to the array substrate, wherein the encapsulation cover plate comprises:
a first base substrate; and
a plurality of organic layers on a side of the first base substrate close to the array substrate; and
a frame sealant in the non-display region and between the array substrate and the encapsulation cover plate, and configured to adhere the array substrate and the encapsulation cover plate, wherein a gap region is between an organic layer of the plurality of the organic layers closest to the frame sealant in a direction from the display region to the frame sealant and the frame sealant, the gap region separates the organic layer of the plurality of the organic layers closest to the frame sealant from the frame sealant, and the gap region is in the non-display region.

2. The display panel according to claim 1, wherein the plurality of the organic layers comprise:
a black matrix on a side of the first base substrate close to the array substrate and defining a plurality of sub-color filter units, wherein the plurality of the sub-color filter units are in one-to-one correspondence with the plurality of the sub-pixels, and the black matrix is configured to enable light emitted by the light-emitting device of each of the sub-pixels to pass through and exit from the corresponding sub-color filter unit; and
a protection layer covering a first surface of the black matrix away from the first base substrate and the plurality of the sub-color filter units, wherein the organic layer of the plurality of the organic layers closest to the frame sealant is the black matrix.

3. The display panel according to claim 1, wherein the plurality of the organic layers comprise:
a black matrix on a side of the first base substrate close to the array substrate and defining a plurality of sub-color filter units, wherein the plurality of the sub-color filter units are in one-to-one correspondence with the plurality of the sub-pixels, and the black matrix is configured to enable light emitted by the light-emitting device of each of the sub-pixels to pass through and exit from the corresponding sub-color filter unit; and
a protection layer covering a first surface of the black matrix away from the first base substrate and a side surface of the black matrix intersecting with the first surface, wherein the organic layer of the plurality of the organic layers closest to the frame sealant is the protection layer.

4. The display panel according to any one of claims 1 to 3, wherein the plurality of the organic layers comprise:
a black matrix on a side of the first base substrate close to the array substrate and defining a plurality of sub-color filter units, wherein the plurality of the sub-color filter units are in one-to-one correspondence with the plurality of the sub-pixels, and the black matrix is configured to enable light emitted by the light-emitting device of each of the sub-pixels to pass through and exit from the corresponding sub-color filter unit;
a protection layer covering at least a portion of the black matrix and the plurality of the sub-color filter units; and
a first spacer on a side of the first base substrate close to the array substrate and on a side of both of the black matrix and the protection layer close to the frame sealant, wherein the organic layer of the plurality of the organic layers closest to the frame sealant is the first spacer.

5. The display panel according to any one of claims 1 to 4, wherein the larger a size of the non-display region in a transverse direction from the black matrix to the frame sealant is, the larger a width of the gap region in the transverse direction is.

6. The display panel according to any one of claims 1 to 4, wherein the larger a size of the frame sealant in a transverse direction from the black matrix to the frame sealant is, the smaller a width of the gap region in the transverse direction is.

7. The display panel according to claim 6, wherein a width of the gap region to the frame sealant is greater than or equal to 10 µm.

8. The display panel according to claim 7, wherein in the transverse direction, a width of the frame sealant is less than or equal to 2 mm, and the width of the gap region is greater than or equal to 100 µm.

9. The display panel according to any one of claims 1 to 8, wherein the protection layer is a planarization layer, and a surface of the planarization layer away from the first base substrate is a flat surface.

10. The display panel according to any one of claims 1 to 9, wherein the encapsulation cover plate further comprises:
an opaque light shielding layer on the first base substrate and covering at least a portion of the gap region.

11. The display panel according to claim 10, wherein the light shielding layer covers an entirety of the gap region.

12. The display panel according to claim 10 or 11, wherein the light shielding layer is on a side of the first base substrate close to the array substrate, and an orthographic projection of the light shielding layer on the first base substrate does not overlap with an orthographic projection of the frame sealant on the first base substrate.

13. The display panel according to claim 10 or 11, wherein the light shielding layer is on a side of the first base substrate close to the array substrate, and an orthographic projection of the light shielding layer on the first base substrate at least partially overlaps with an orthographic projection of the frame sealant on the first base substrate.

14. The display panel according to claim 10 or 11, wherein the light shielding layer is on a side of the first substrate away from the array substrate, and an orthographic projection of the light shielding layer on the first substrate at least partially overlaps with an orthographic projection of the frame sealant on the first substrate.

15. The display panel according to any one of claims 10 to 14, wherein a material of the light shielding layer is a metal material.

16. The display panel according to any one of claims 4 to 15, wherein the array substrate further comprises:
a pixel definition layer defining the plurality of the sub-pixels, wherein an orthographic projection of the black matrix on the first base substrate is within an orthographic projection of the pixel definition layer on the first substrate.

17. The display panel according to claim 16, further comprising:
a second spacer on a side of the pixel definition layer close to the black matrix, wherein a space is between the second spacer and the protection layer, an orthographic projection of the second spacer on the first base substrate is within the orthographic projection of the pixel definition layer on the first base substrate, and is within the orthographic projection of the black matrix on the first base substrate; and
a height of the second spacer in a direction perpendicular to the first base substrate is smaller than a height of the first spacer in the direction perpendicular to the first base substrate.

18. The display panel according to any one of claims 1 to 17, further comprising:
a filling material layer which is filled between the array substrate and the encapsulation cover plate and comprises a first portion in the display region and a second portion in a frame region,
wherein the first portion covers the light-emitting device, and the second portion fills the gap region.

19. The display panel according to claim 18, wherein the filling material layer is an elastic layer, in a case that the display panel is applied with a pressure in a direction perpendicular to the first base substrate, a thickness of the elastic layer in a direction perpendicular to the first substrate decreases.

20. A manufacturing method of a display panel, comprising:
providing an array substrate, wherein the array substrate comprises a display region and a non-display region surrounding at least a part of the display region, the display region comprises a plurality of pixels arranged in an array, each of the pixels comprises a plurality of sub-pixels, and each of the sub-pixels comprises a light-emitting device;
forming an encapsulation cover plate, comprising:
providing a first base substrate; and
forming a plurality of organic layers on a side of the first base substrate close to the array substrate;
forming a frame sealant, wherein the frame sealant is located in the non-display region; and
allowing the array substrate to be opposite to the encapsulation cover plate and bonding the array substrate with the encapsulation cover plate, wherein the frame sealant is located between the array substrate and the encapsulation cover plate, the frame sealant adheres the array substrate and the encapsulation cover plate, a gap region is provided between an organic layer of the plurality of the organic layers closest to the frame sealant in a direction from the display region to the frame sealant and the frame sealant, the gap region separates the organic layer of the plurality of the organic layers closest to the frame sealant from the frame sealant, and the gap region is located in the non-display region.

21. A display apparatus comprising the display panel according to any one of claims 1 to 19.
